(19) 

Europäisches
Patentamt
European
Patent Office
Office européen
des brevets

(11) **EP 1 094 598 B1**

(12) **EUROPEAN PATENT SPECIFICATION**

(45) Date of publication and mention
of the grant of the patent:
**03.12.2008 Bulletin 2008/49**

(51) Int Cl.:
*H03F 1/08* (2006.01)

(21) Application number: **00660179.3**

(22) Date of filing: **05.10.2000**

(54) **Frequency compensation of an amplifier**

Verstärker mit Frequenzkompensation

Amplificateur à compensation de fréquence

(84) Designated Contracting States:
**AT BE CH CY DE DK ES FI FR GB GR IE IT LI LU
MC NL PT SE**

(30) Priority: **18.10.1999 FI 992245**

(43) Date of publication of application:
**25.04.2001 Bulletin 2001/17**

(73) Proprietor: **Micro Analog Systems OY
02770 Espoo (FI)**

(72) Inventor: **Sillanpää, Tero
c/o Micro Analog Systems Oy
02771 Espoo (FI)**

(74) Representative: **Äkräs, Tapio Juhani et al
Oy Kolster Ab
Iso Roobertinkatu 23
P.O. Box 148
00121 Helsinki (FI)**

(56) References cited:
**EP-A- 0 766 164          EP-A- 0 939 484
US-A- 5 392 000          US-A- 5 945 818**

- **PATENT ABSTRACTS OF JAPAN vol. 2000, no.
03, 30 March 2000 (2000-03-30) & JP 11 340753 A
(CANON INC), 10 December 1999 (1999-12-10)**
- **PATENT ABSTRACTS OF JAPAN vol. 018, no. 577
(E-1625), 4 November 1994 (1994-11-04) & JP 06
216662 A (ASAHI KASEI MICRO SYST KK), 5
August 1994 (1994-08-05)**
- **KOH H Y ET AL: "OPASYN: A COMPLILER FOR
CMOS OPERATIONAL AMPLIFIERS" IEEE
TRANSACTIONS ON COMPUTER AIDED DESIGN
OF INTEGRATED CIRCUITS AND SYSTEMS, IEEE
INC. NEW YORK, US, vol. 9, no. 2, 1 February 1990
(1990-02-01), pages 113-125, XP000100792 ISSN:
0278-0070**

**Description**

The invention relates to frequency compensation of an amplifier, particularly a regulator amplifier with a heavy capacitive load and a wide variation of load current.

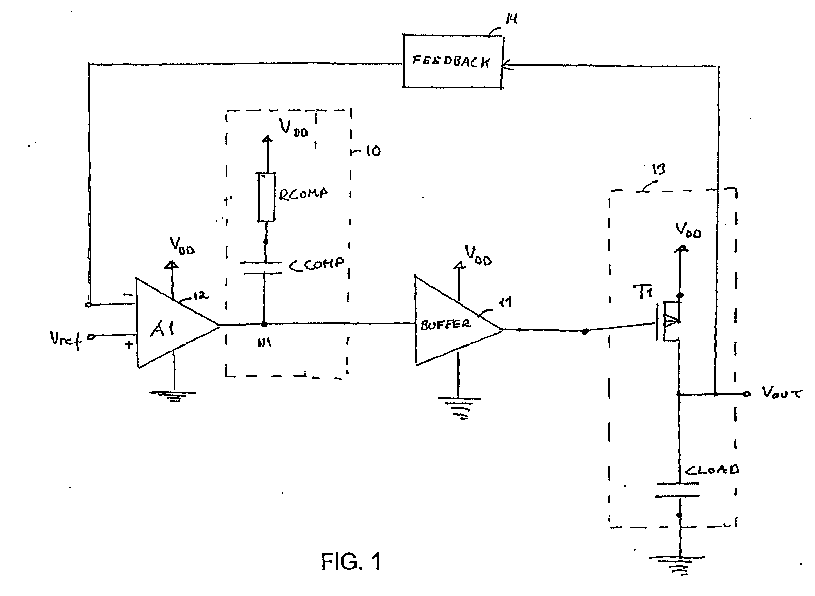

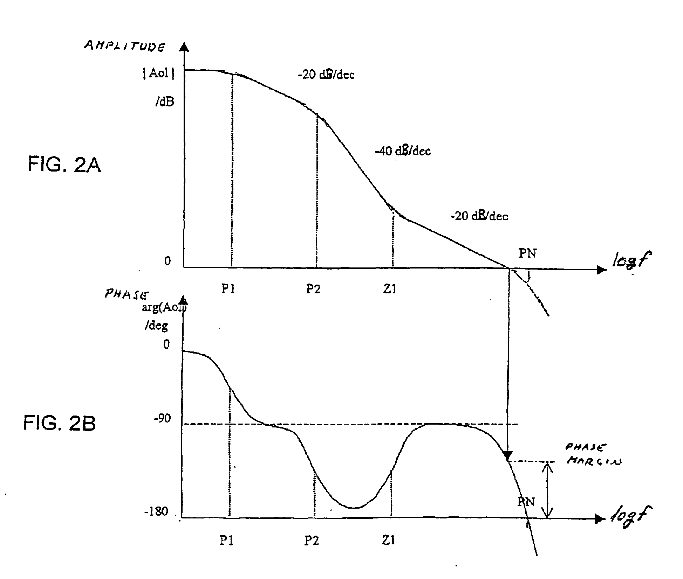

Voltage regulators are commonly used in electronic devices for producing a regulated stable operating voltage see e.g. US 5 945 818. Figure 1 shows the schematic structure of a voltage regulator. The voltage regulator is based on a transconductance amplifier 12 which converts the voltage difference of input voltages to an output current. In Figure 1, a feedback 14 (direct or scaled) is provided to the amplifier 12 from an output voltage VOUT of the regulator. The output voltage VOUT is regulated in relation to a reference voltage Vref connected to a non-inverting input of the amplifier 12. The transconductance amplifier 12 has a high input impedance and a high output impedance and typically low impedances in the nodes inside the amplifier. The amplifier 12 output comprises a frequency compensation 10 which consists of a series connection of a compensation capacitor CCOMP and a compensation resistance RCOMP between a node N1 and an operating voltage VDD. On this account, a first dominant pole P1 is formed in a node N1 to a frequency response of the regulator, as illustrated in Figures 2A and 2B. Figure 2A is a Bode plot showing an amplitude response of the regulator as a function of frequency (decibel, DB, as a unit). Figure 2B is a Bode plot showing a phase response of the regulator as a function of frequency (degree, deg, as a unit). Mathematically the formation of the first dominant pole P1 in the node N1 can be illustrated by the following equation

$$\omega_{P1} = \frac{1}{(R_{N1} + RCOMP) \cdot CCOMP}, \qquad (1)$$

where $R_{N1}$ is a resistance of the node N1. The resistance $R_{N1}$ is mainly determined on the basis of an output resistance of the transconductance amplifier 12.

Since the resistance RCOMP is in series with the capacitance CCOMP, a transfer zero Z1 is formed in the node N1 in accordance with the following equation

$$\omega_{Z1} = \frac{1}{RCOMP \cdot CCOMP}. \qquad (2)$$

A buffer 1 arranges an output stage 13 of the high impedance node N1 to a low impedance input. The buffer 11 can be a two-stage emitter follower, for example. The possible internal low impedance nodes in the buffer 11 and the output node produce non-dominant poles PN to the frequency response of the regulator, as illustrated in Figures 2A and 2B.

The output stage 13 comprises a high power PMOS transistor T1 and an external load capacitance CLOAD, both having a high capacitance value typically in the range of 1 microfarad. The gain of the output stage 13 exceeds 1 and a second dominant pole P2 is therefore formed in the output node VOUT to the frequency response of the regulator. The formation of the second dominant pole P2 can be presented by the

$$\omega_{Z1} = \frac{1}{RCOMP \cdot CCOMP}. \qquad (2)$$

equation

$$\omega_{P2} = \frac{g_{d6}}{CLOAD}, \qquad (3)$$

where $g_{d6} = \lambda \cdot I_{d6}$ is an output conductance of the PMOS transistor T1 and $I_{d6}$ is the current of the transistor T1.

As Figure 2A shows, each dominant pole increases the steepness of the slope of the frequency response by -20 dB/decade (a decade refers to a decupled frequency, e.g. the decade may be a frequency range from 20 kHz to 200 kHz; in Figure 2A the x-axis in the Bode plot is logarithmic i.e. log(frequency) in which case the frequency decuples at even intervals), and after the two poles P1 and P2 the slope is -40 dB/dec. Then again, a transfer zero Z1 reduces the steepness of the slope by 20 dB/dec. As to the stability of the regulator, it is important that the slope is -20 dB/decade at the most, when the curve meets a unit gain frequency (0 dB frequency), since this provides an adequate phase margin for a stable operation. As the regulator described includes two dominant poles P1 and P2, it is very important that the transfer zero Z1 is before the 0 dB frequency in order to meet the stability condition. This object is achieved in Figure 2A, where the phase margin is also sufficient. The phase margin is the difference between the phase that occurs at the 0 dB frequency and the -180 degree phase.

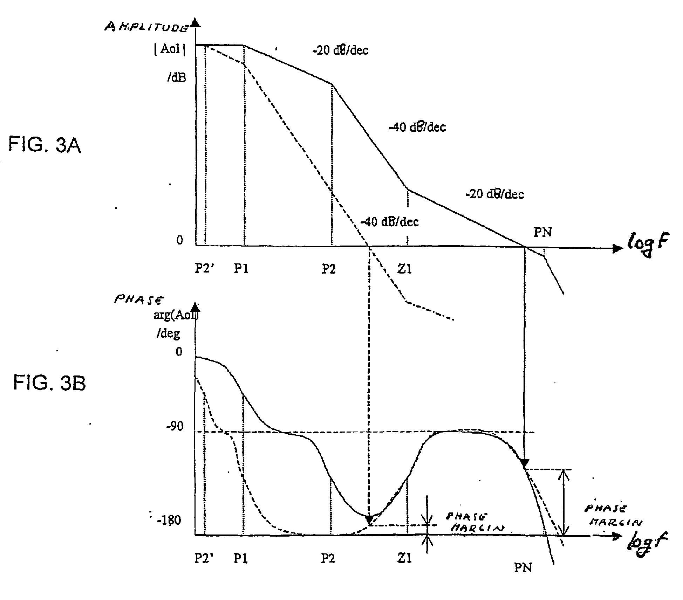

A problem is that an output conductance $g_{d6}$ of the PMOS transistor T1 is proportioned to an output current $I_{d6}$ of the transistor T1, which may vary from zero milliampere (mA) to dozens of milliamperes. On this account the dominant pole P2 moves within a relatively large range in the frequency domain. The Bode plots in Figures 3A and 3B show the effect of this motion. It is assumed here that P2 is a dominant pole in the node VOUT with a high transistor T1 current $I_{d6}$ and P2' is a corresponding pole with a low output current $I_{d6}$. It is also assumed that the phase margin of the regulator is optimized to a high output current $I_{d6}$, whereby the amplitude and phase responses for the pole P2 are identical in Figures 3A and 3B (solid line) with the ones in Figures 2A and 2B. In other words, the regulator is stable. With a low output current $I_{d6}$ the pole P2' has moved to a very low frequency. Consequently, the amplitude response reaches the unit gain frequency before the transfer zero Z1 at a slope of -40 dB/decade as illustrated with a dashed line in Figure 3A. A corresponding phase characteristic with a low output current $I_{d6}$ is illustrated with a dashed line in Figure 3B. This shows that the phase margin may be too small. A small phase margin may, in turn, cause ringing at the regulator output, when transients occur in the load.

It is an object of the invention to provide frequency stabilization that eliminates the problems presented above.

The invention relates to an amplifier circuit, characterized by what is disclosed in claim 1.

The basic idea of the invention is that the value of a compensation resistance is adaptively adjusted as a function of load current. The adjustment ratio is selected in such a manner that when a change in load current changes the second dominant pole and thus the position of a unit gain frequency in frequency domain, the value of the compensation resistance and thus the position of a transfer zero also move in the frequency domain so that the transfer zero is always at a lower frequency than the unit gain frequency of the amplifier circuit. An adequate phase margin and stability are thus ensured for all load current values, and consequently an undesired ringing is avoided at the amplifier output.

In a preferred embodiment of the invention the adjustable compensation resistance is implemented using one or more transistors, at least one of which has a resistance that is adjusted according to the load current. However, the compensation resistance may be any combination of adjustable or adjustable or fixed resistances.

In the following the invention will be described in greater detail by means of preferred embodiments with reference to the accompanying drawings, in which

Figure 1 is a switching diagram illustrating a prior art voltage regulator,
Figures 2A, 2B, 3A and 3B are Bode plots illustrating the amplitude and phase of the voltage regulator in Figure 1 as a function of frequency,
Figure 4 is a switching diagram showing an amplifier circuit with a frequency compensation according to the invention, and
Figures 5A and 5B are Bode plots illustrating the amplitude and phase of the amplifier circuit in Figure 4 as a function of frequency.

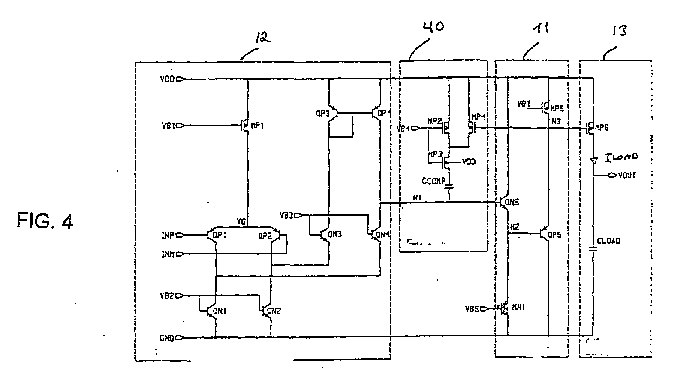

With reference to Figure 4 an amplifier circuit according to a preferred embodiment of the invention comprises a transconductance amplifier 12, a frequency compensation unit 40, a buffer stage 11 and an output stage 13. The transconductance amplifier 12, the buffer stage 11 and the output stage 13 may be identical with the ones in Figure 1, when the invention primarily relates to the structure and operation of the frequency compensation unit 40. However, in the following, exemplary structures will be described also for the transconductance amplifier 12, the buffer stage 11 and the output stage 13.

The transconductance amplifier 12 is formed from a differential stage formed of bipolar transistors QP1 and QP2 of type P and a PMOS field effect transistor MP1, current loads QP3 and QP4 and an output stage formed of bipolar transistors QN3 and QN4 of type N. VB1, VB2 and VB3 are bias voltages of transistors MP1, QN1 and QN2 and transistors QN3 and QN4. VDD refers to an operating voltage and GND to a ground potential. Input INP is a non-inverting input, which is connected to a reference voltage Vref in Figure 1. Input INM is an inverting input, to which there is a feedback from an output VOUT in Figure 1. The amplifier 12 is characterized by a high input impedance and a high output impedance and low impedances in the internal nodes. However, it should be noted that the invention is not intended to be restricted to the exemplary implementation of the amplifier 12 shown in Figure 4.

The buffer stage 11 is a two-stage emitter follower. The first emitter follower is formed of a bipolar transistor QN5 of type N and an NMOS field effect transistor MN1 in series. This stage has a high input impedance and a low output impedance in the node N2. The second emitter follower stage is formed of a bipolar transistor QP5 of type P and a PMOS field effect transistor MP5 in series. This emitter follower too, has a high input impedance and a low output impedance in the node N3. The buffer stage 11 thus distinguishes the high impedance node N1 from the high-capacity output stage 13. The output stage 13 must be driven with a low impedance in order for the high MP&,n capacitive load to form non-dominant poles PN. VP1 and VP5 are bias voltages for the transistors MP5 and MN1. It should be noted that the invention is not intended to be restricted to the exemplary implementation of the buffer circuit 11 shown in Figure 4.

The output stage 13 is formed of a large PMOS field effect transistor MP6 of pass type and a high load capacitance in series therewith, such as 1 $\mu$F. The output stage 13 feeds the load current ILAD of the load, which varies according to the load. At the same time the position of the dominant pole P2 caused by the node VOUT varies, as explained above with reference to Figures 3A and 3B.

The frequency compensation unit 40 according to a preferred embodiment of the invention comprises a compensating capacitance CCOMP and a compensation resistance formed of PMOS field effect transistors MP2, MP3 and MP4. Transistors MP2 and MP3 are connected in series with the capacitance CCOMP between a node N1 and an operating voltage VDD. The transistors MP2 and MP3 are also biased with a constant voltage VP4, in which case the transistors have a constant resistance. A transistor MP4 is connected next to the transistor MP2. The transistor MP4 is biased with a gate voltage of a pass PMOS transistor MP6 so that the MP4 operates at a linear range as an adjustable resistance. As the gate voltage of the transistor MP6 is directly proportional to the load current ILOAD, the conductance of the transistor MP4 also changes proportionally to the load current $I_{d6}$. Hence, the resistance value of the compensation stage 40 and thereby the position of the transfer zero Z1 in the frequency domain depends on the load current $I_{d6}$. When the resistance values of the transistors MP2, MP3 and MP4 are suitably measured, the transfer zero Z1 can be held below the unit resistance frequency for all load current $I_{d6}$ values. The frequency of the transfer zero Z1, described in greater detail, is obtained from the following equation

$$\omega_{Z1} = \frac{1}{(R_{MP3} + R_{MP2} \parallel R_{MP4}) \cdot CCOMP}, \qquad (4)$$

where $R_{MP3}$ and $R_{MP2}$ are the fixed resistances of the transistors MP2 and MP3, and $R_{MP4}$ is an adjustable resistance of the transistor MP4 depending on the current load $I_{d6}$ in accordance with equation (5)

$$R_{MP4} = \frac{L_{MP4}}{K'_p \cdot W_{MP4}(V_{GS4} - V_{Tp})}, \qquad (5)$$

where $L_{MP4}$ is the length of an MP4 channel, $K'_p$ is a process parameter, $W_{MP4}$ is the width of the MP4 channel, $V_{Tp}$ is the threshold voltage of the MP4 and in which

$$V_{GS4} = V_{GS6} = \sqrt{\frac{2 \cdot I_{D6}}{W_{MP6} \cdot K'_p}} + V_{Tp}, \qquad (6)$$

where $W_{MP6}$ is the width of an MP6 channel.

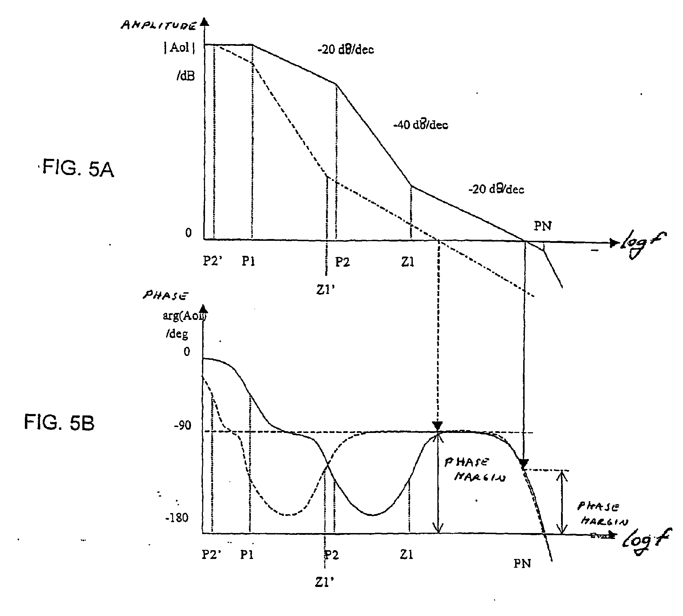

The frequency dependency of the transfer zero Z1 on the load current $I_{D6}$ is not as linear as the frequency dependency of the pole P2, but the use thereof enables to stabilize the loop for all load current $I_{d6}$ values, when the adjustable resistance $R_{MP4}$ is connected in series or in parallel with the fixed resistances $R_{MP2}$ and $R_{MP3}$. Figures 5A and 5B illustrate how the changing resistance of the invention affects the stability.

Pole P2 again represents a dominant pole caused by the node VOUT at a high current $I_{D6}$ value. A solid line in Figures 5A and 5B shows a corresponding amplitude response and phase response. The phase margin is optimized for this value in the same way as shown in Figures 2A, 2B, 3A and 3B. P2' represents a dominant pole caused by the node VOUT at a low load current $I_{D6}$ value in the same way as in Figures 2A, 2B, 3A and 3B. On account of the adjustable compensation resistance of the invention the position of the transfer zero also moves in the frequency domain to a frequency which is below the new unit gain frequency, as the transfer zero Z1' illustrates in Figures 5A and 5B. Consequently, the amplitude response meets the unit gain frequency at a slope of -20 dB/decade, which in turn provides an adequate phase margin in order to ensure stability.

Hence, the inadequate phase margin at low load current values shown in Figure 3B can be avoided by means of the invention, which was the drawback with the prior art.

The implementation of the adjustable compensation resistance shown in Figure 4 is only one of several possibilities that a person skilled in the art may consider depending on the application.

The Figures and the specification merely describe the preferred embodiments of the invention. However, the invention can be implemented in various ways and can be modified within the scope of the appending claims.

## Claims

1. An amplifier circuit comprising
   a transconductance amplifier (12) having a high input impedance and a high output impedance,
   an output amplifying stage (13) having a capacitive input impedance and a high load capacitance (CLOAD) at the output thereof,
   a buffer stage (11) matching the transconductance amplifier (12) to the capacitive input of the output amplifying stage (13) of the high impedance output,
   a frequency compensation stage (10) including a compensating capacitance (CCOMP) and a compensation resistance (RCOMP MP2-4) connected in series between the output of the transconductance amplifier and operating voltage (VDD),
   **characterized in that**
   the value of said compensation resistance (RCOMP, MP2, MP3, MP4) can be adjusted in proportion to a load current ($I_{d6}$) of the output amplifying stage (13) in such a manner that the desired frequency stability of the amplifier circuit is retained for all load current values.

2. An amplifier circuit as claimed in claim 1, **characterized in that** the value of the compensation resistance (RCOMP, MP2, MP3, MP4) is adjusted in proportion to the load current ($I_{d6}$) of the output amplifying stage (13) in such a manner that a transfer zero Z1 caused by the compensating capacitance (CCOMP) and the compensation resistance is for all load current values at a frequency that is lower than a unit gain frequency in a frequency response of the amplifier circuit.

3. An amplifier circuit as claimed in claim 1 and 2, **characterized in that** the adjustable compensation resistance comprises at least one transistor (MP4), the resistance of which is adjusted in proportion to the load current.

4. An amplifier circuit as claimed in claim 3, **characterized in that** the compensation resistance comprises at least one transistor (MP4), the resistance of which is adjusted in proportion to the load current, and at least one transistor (MP2, MP3) biased to have a fixed resistance.

5. An amplifier circuit as claimed in claim 3, **characterized in that** the compensation resistance comprises at least one transistor (MP4), the resistance of which is adjusted in proportion to the load current, and at least one fixed resistance.

6. An amplifier circuit as claimed in claim 4 or 5, **characterized in that** the compensation resistance comprises two transistors (MP2, MP3) connected in series, and biased to have a fixed resistance, and a third transistor (MP4), whose resistance is adjusted in proportion to the load current ($I_{d6}$), is connected in parallel with one of the transistors.

7. An amplifier circuit as claimed in claim 3, 4, 5 or 6, **characterized in that** the transistors (MP2, MP3, MP4) are field effect transistors, preferably PMOS field effect transistors.

8. An amplifier circuit as claimed in any one of the preceding claims, **characterized in that** the output amplification stage (13) comprises a transistor (MP6, T1), preferably a PMOS field effect transistor, and a series connection of said load capacitance (CLOAD), and **in that** said output (VOUT) is between the transistor and the load capacitance.

9. An amplifier circuit as claimed in any one of the preceding claims, **characterized in that** the amplifier is arranged to operate as a voltage regulator.

**10.** An amplifier circuit as claimed in any one of the preceding claims, **characterized in that** a first dominant pole (P1) is formed at the output of the transconductance amplifier (12) and a second pole (P2) at the output of the output amplification stage (13) to the frequency response of the amplifier circuit, and **in that** the position of said second dominant pole (P2) and thus the unit gain frequency moves in the frequency domain depending on the load current ($I_{d6}$).

**Patentansprüche**

**1.** Verstärkerschaltung aufweisend
einen Transkonduktanzverstärker (12) mit einer hohen Eingangsimpedanz und einer hohen Ausgangsimpedanz,
eine Ausgangsverstärkerstufe mit einer kapazitiven Eingangsimpedanz und einer hohen Belastungskapazitanz (CLOAD) an deren Ausgang,
eine Pufferstufe (11) zum Anpassen des Transkonduktanzverstärkers (12) an den kapazitiven Eingang der Ausgangsverstärkerstufe (13) des Ausgangs mit der hohen Impedanz,
eine Frequenzausgleichsstufe (10) mit einer Ausgleichskapazitanz (CCOMP) und einem Ausgleichswiderstand (RCOMP • MP2-4), die in Reihe zwischen dem Ausgang des Transkonduktanzverstärkers und der Arbeitsspannung (VDD) geschaltet sind,
**dadurch gekennzeichnet, daß**
der Wert des Ausgleichswiderstandes (RCOMP, MP2, MP3, MP4) derart proportional zu einem Arbeitsstrom ($I_{d6}$) der Ausgangsverstärkerstufe (13) einstellbar ist, daß die gewünschte Frequenzstabilität der Verstärkerschaltung für alle Arbeitsstromwerte erhalten bleibt.

**2.** Verstärkerschaltung nach Anspruch 1, **dadurch gekennzeichnet, daß** der Wert des Ausgleichswiderstandes (RCOPM, MP2, MP3, MP4) derart proportional zu dem Arbeitsstrom ($I_{d6}$) der Ausgangsverstärkerstufe (13) eingestellt ist, daß eine durch die Ausgleichskapazitanz (CCOMP) und den Ausgleichswiderstand hervorgerufe Nullübertragung (transfer zero) (Z1) für alle Arbeitsstromwerte eine Frequenz aufweist, die niedriger als eine Einheitsverstärkungsfrequenz in einem Frequenzgang der Verstärkerschaltung ist.

**3.** Verstärkerschaltung nach einem der Ansprüche 1 oder 2, **dadurch gekennzeichnet, daß** der einstellbare Ausgleichswiderstand mindestens einen Transistor (MP4) aufweist, dessen Widerstand proportional zu dem Arbeitsstrom eingestellt wird.

**4.** Verstärkerschaltung nach Anspruch 3, **dadurch gekennzeichnet, daß** der Ausgleichswiderstand mindestens einen Transistor (MP4), dessen Widerstand proportional zu dem Arbeitsstrom eingestellt ist, und mindestens einen Transistor (MP2, MP3) aufweist, der derart eingestellt ist, daß er einen festen Widerstand hat.

**5.** Verstärkerschaltung nach Anspruch 3, **dadurch gekennzeichnet, daß** der Ausgleichswiderstand mindestens einen Transistor (MP4), dessen Widerstand proprotional zu dem Arbeitsstrom eingestellt ist, und mindestens einen festen Widerstand aufweist.

**6.** Verstärkerschaltung nach Anspruch 4 oder 5, **dadurch gekennzeichnet, daß** der Ausgleichswiderstand zwei in Reihe geschaltete Transistoren (MP2, MP3) aufweist, die derart eingestellt sind, daß sie einen festen Widerstand haben, und ein dritter Transistor (MP4), dessen Widerstand proportional zu dem Arbeitsstrom eingestellt ist, parallel zu einem der Transistoren geschaltet ist.

**7.** Verstärkerschaltung nach einem der Ansprüche 3, 4, 5 oder 6, **dadurch gekennzeichnet, daß** die Transistoren (MP2, MP3, MP4) Feldeffekttransistoren, vorzugsweise PMOS Feldeffekttransistoren, sind.

**8.** Verstärkerschaltung nach einem der vorangehenden Ansprüche, **dadurch gekennzeichnet, daß** die Ausgangsverstärkerstufe (13) einen Transistor (MP6, T1), vorzugsweise einen PMOS Feldeffekttransistor, und eine Reihenschaltung der Belastungskapazitanz (CLOAD) aufweist, und daß der Ausgang (VOUT) zwischen dem Transistor und der Belastungskapazitanz liegt.

**9.** Verstärkerschaltung nach einem der vorangehenden Ansprüche, **dadurch gekennzeichnet, daß** der Verstärker derart ausgebildet ist, daß dieser als Spannungsregler dient.

**10.** Verstärkerschaltung nach einem der vorangehenden Ansprüche, **dadurch gekennzeichnet, daß** ein erster dominanter Pol (P1) an dem Ausgang des Transkonduktanzverstärkers (12) und ein zweiter Pol (P2) an dem Ausgang der Ausgangsverstärkerstufe (13) zu dem Frequenzgang der Verstärkerschaltung ausgebildet ist, und daß sich die Position des zweiten dominanten Poles (P2) und somit die Einheitsverstärkungsfrequenz in der Frequenzdomäne in Abhängigkeit von dem Arbeitsstrom ($I_{d6}$) bewegt.

**Revendications**

1. Un circuit amplificateur comprenant
un amplificateur de transconductance (12) ayant une impédance d'entrée élevée et une impédance de sortie élevée,
un étage d'amplification de sortie (13) ayant une impédance d'entrée capacitive et une capacité de charge (CLOAD) élevée en sortie de celui-ci,
un étage tampon (11) pour adapter l'amplificateur de transconductance (12) à l'entrée capacitive de l'étage d'amplification de sortie (13) de la sortie à impédance élevée,
un étage de compensation de fréquence (10) comprenant une capacité de compensation (CCOMP) et une résistance de compensation (RCOMP . MP2-4) montées en série entre la sortie de l'amplificateur de transconductance et la tension de fonctionnement (VDD),
<u>**caractérisé en ce que**</u>
la valeur de ladite résistance de compensation (RCOMP, MP2, MP3, MP4) peut être réglée proportionnellement au courant de charge ($I_{d6}$) de l'étage d'amplification de sortie (13) de telle sorte que la stabilité de fréquence désirée pour le circuit amplificateur soit maintenue pour toutes les valeurs du courant de charge.

2. Un circuit amplificateur selon la revendication 1, **caractérisé en ce que** la valeur de la résistance de compensation (RCOMP, MP2, MP3, MP4) est réglée proportionnellement au courant de charge ($I_{d6}$) de l'étage d'amplification de sortie (13) de telle manière qu'un zéro de transfert Z1 créé par la capacité de compensation (CCOMP) et la résistance de compensation est pour toutes les valeurs du courant de charge à une fréquence qui est inférieure à une fréquence de gain unitaire dans une réponse en fréquence du circuit amplificateur.

3. Un circuit amplificateur selon les revendications 1 et 2, **caractérisé en ce que** la résistance de compensation réglable comprend au moins un transistor (MP4), dont la résistance est réglée proportionnellement au courant de charge.

4. Un circuit amplificateur selon la revendication 3, **caractérisé en ce que la résistance de compensation** réglable comprend au moins un transistor (MP4), dont la résistance est réglée proportionnellement au courant de charge et dont au moins un transistor (MP2, MP3) est polarisé pour avoir une résistance fixe.

5. Un circuit amplificateur selon la revendication 3, **caractérisé en ce que** la résistance de compensation comprend au moins un transistor (MP4) dont la résistance est réglée proportionnellement au courant de charge et au moins une résistance fixe.

6. Un circuit amplificateur selon les revendications 4 ou 5, **caractérisé en ce que** la résistance de compensation comprend deux transistors (MP2, MP3) montés en série et polarisés pour avoir une résistance fixe, et un troisième transistor (MP4), dont la résistance est réglée proportionnellement au courant de charge ($I_{d6}$), qui est monté en parallèle avec l'un des transistors.

7. Un circuit amplificateur selon les revendications 3, 4, 5 ou 6, **caractérisé en ce que** les transistors (MP2, MP3, MP4) sont des transistors à effet de champ, de préférence des transistors à effet de champ PMOS (MOS à canal P).

8. Un circuit amplificateur selon l'une quelconque des revendications précédentes, **caractérisé en ce que** l'étage d'amplification de sortie (13) comprend un transistor (MP6, T1), de préférence un transistor à effet de champ PMOS, et un montage en série de ladite capacité de charge (CLOAD) et dont ladite sortie (VOUT) est entre le transistor et la capacité de charge.

9. Un circuit amplificateur selon l'une quelconque des revendications précédentes, **caractérisé en ce que** l'amplificateur est adapté pour fonctionner comme régulateur de tension.

10. Un circuit amplificateur selon l'une quelconque des revendications précédentes, **caractérisé en ce qu'**un premier pôle dominant (P1) est formé à la sortie de l'amplificateur de transconductance (12) et un second pôle (P2) à la sortie de l'étage d'amplification de sortie (13) à la réponse en fréquence du circuit amplificateur, et **en ce que** la position dudit second pôle dominant (P2) et donc la fréquence de gain unitaire, se déplacent dans le domaine harmonique en fonction du courant de charge ($I_{d6}$).

FIG. 1

EP 1 094 598 B1

FIG. 2A

FIG. 2B

FIG. 3A

FIG. 3B

FIG. 4

FIG. 5A

FIG. 5B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5945818 A